# EUROPEAN PATENT APPLICATION

(11) **EP 4 443 523 A1**
(43) Date of publication of application: **09.10.2024**
(21) Application number: 22901485.7
(22) Date of filing: 06.07.2022
(51) Int. Cl.: H01L 31/18, H01L 31/048

(54) **TABBING DEVICE FOR MANUFACTURING SOLAR CELL MODULE PREVENTING OVERSOLDERING**

(30) Priority: 02.12.2021 KR 20210171094
(71) Applicant: Hanwha Solutions Corporation, Jung-gu Seoul 04541 (KR)
(72) Inventor: LEE, Min Su, Seoul 04541 (KR); KIM, Hyung Do, Seoul 04541 (KR); CHOI, Jin Uk, Seoul 04541 (KR); LIM, Moon Taek, Seoul 04541 (KR); KIM, Sung Jin, Seoul 04541 (KR)
(74) Representative: HGF
(86) International application number: PCT/KR2022/009797
(87) International publication number: WO 2023/101124

(57) **Abstract**

An over-soldering prevented tabbing device for manufacturing solar cell modules is disclosed in which the over-soldering is prevented from occurring in the tabbing device for performing the soldering process in manufacturing the solar cell modules. The over-soldering prevented tabbing device according to an embodiment of the present disclosure includes a solar cell module cell that is transported on a conveyor by a unit of cell; a soldering head installed above the solar cell module cell and having a built-in heat source that provides heat to solder the flux coated on the transported solar cell module cell; a driver reciprocating the soldering head in a direction in which the conveyor moves; and a controller controlling the driver.

## Description

### TECHNICAL FIELD

The present disclosure relates to an over-soldering prevented tabbing device for manufacturing solar cell modules, and more particularly, to an over-soldering prevented tabbing device for manufacturing solar cell modules that is capable of preventing the occurrence of over-soldering in a tabbing device for performing a soldering process when manufacturing the solar cell modules.

### BACKGROUND ART

It is spurring to discover new energy sources around the world, and among such energy sources, renewable energy is attracting attention with the advantage of being environmentally friendly, unlike other power generation methods. In order to convert infinite and pollution-free solar energy into electrical energy, solar cells that serve to convert solar energy into electrical energy are required.

These solar cells are manufactured by bonding semiconductor materials into p-n junction using a diffusion method and allows a small amount of current to flow by the photoelectric effect when receiving light, and thus a conventional solar cell is mostly made up of a large area of p-n junction diodes and functions as a unit solar cell when the electromotive force generated between both ends of the p-n junction diode is connected to an external circuit.

However, the solar cells are individually manufactured in a thin plate shape with a size of 156 mm x 156 mm, and each of these solar cells has an output value of about 4 W. When trying to obtain the desired output for power generation, it is required that a certain number of the solar cells are connected in series and the outputs are summed up to the desired output, and, above all, a technology for focusing sunlight is essential at this time.

A solar cell is manufactured on a single crystal or polycrystalline silicon substrate and is vulnerable to physical shock and external air, so that the solar cell usually requires a protective layer structure.

These series of processes are called solar cell module manufacturing processes, and the solar cell module manufacturing process may be divided into five main processes: a cell test process, a tabbing-string process, a layup process, a lamination process, and a module test process.

First, in the cell test process, cells with various electrical properties are tested and sorted into cells with similar electrical properties, and secondly, in the tabbing-string process, conductive ribbons are bonded to front and rear surfaces of the solar cells in a staggered manner so as to connect the solar cells in series. Thirdly, in the layup process, a series of the solar cells formed in the string process are arranged horizontally again to form the desired shape, and then a low-iron tempered glass, ethylene vinyl acetate (EVA) films, and a backsheet are stacked thereon. Fourthly, in the lamination process, the stacked materials for the solar cell module are compressed under high temperature, to thereby allow the solar cell module to withstand impact and be waterproof at the same time. Lastly, in the module test process, it is verified whether the completed solar cell module can normally implement output.

At this time, the term 'tabbing' refers to bonding solar cells and ribbons and the term 'string' refers to arranging solar cells in series, and the tabbing process is explained in more detail as follows.

The tabbing process is a process for connecting positive (+) and negative (-) polarities of several cells in series in such a way that the negative (-) electrode of one cell is connected to the positive (+) electrode of the next cell with the ribbon sequentially and continuously, so when the ribbon is cut in the middle or is not bonded properly, the solar cell module product is entirely defective, which makes the tabbing process important step for determining the quality of the module. In order to perform the tabbing process, a number of solar cells, which are capable of implementing the desired output, are arranged on an upper surface of the tabbing device in the form of a square plate in accordance with rows and columns. At this time, for each of the individual cells, soldering flux is applied to the areas where the ribbon is to be attached at the top and bottom of the cell, and a ribbon wire is placed on the electrode on which the flux is applied. In this state, the ribbon is fixed to each unit solar cell by soldering the contact area in various ways. In this process, the soldering may be performed directly by a person or automatically by a machine. Even when the soldering is performed automatically by a machine, it may be divided into Hot Air, Laser, Induction, IR lamp, and resistance heating method depending on the method.

Laser, induction, and resistance heating methods transfer heat locally, thereby minimizing and integrating the range, but have the disadvantage that the process device for implementing this method is expensive, and Hot Air and IR lamp methods are methods of transferring energy by using hot air or solar radiant heat and have the advantage of a wide heat transfer range, but have the disadvantage of transferring more heat than necessary to the solar cell.

However, in the case of the conventional tabbing device, when the tabbing device is stopped for any reasons, the hot lamp is positioned at the top of the cell where the soldering has been completed, and thus, there is a problem that an over-soldering occurs at the rear surface of the cell which is the most vulnerable point of the cell. To solve this problem, the height of the Ag pad of the cell is adjusted or a cooling device is applied, but in this case, there are problems such as an increase in the cost of the cell, destruction of soldering temperature, a decrease in the lamp life, and an increase in air consumption.

### DETAILED DESCRIPTION OF INVENTION

### TECHNICAL PROBLEM

According to the present disclosure, it is intended to provide an over-soldering prevented tabbing device for manufacturing solar cell modules in which the heat source moves from the position of a target cell to be worked to the position of a standby cell when the tabbing device stops and returns to the original position when the tabbing is re-operated, thereby preventing over-soldering.

### TECHNICAL SOLUTION TO PROBLEM

An over-soldering prevented tabbing device according to an aspect of the present disclosure may include a solar cell module cell that is transported on a conveyor by a unit of cell; a soldering head installed above the solar cell module cell and having a built-in heat source that provides heat to solder the flux coated on the transported solar cell module cell; a driver reciprocating the soldering head in a direction in which the conveyor moves; and a controller controlling the driver.

At this time, the soldering head may include an infrared lamp.

At this time, when the tabbing device stops, the controller may control the driver to move the heat source from a first position of a first cell that is positioned under the heat source and on which a soldering is performed among the solar cell module cells to a second position that is a cell position of one of adjacent standby cells.

At this time, the controller may control the driver to position the heat source over the second cell that is closest to the first cell among the standby cells.

At this time, the controller may control the driver to return the heat source to the first position from the second position when the tabbing device is re-operated.

At this time, the soldering head may be guided and transported with being supported by a straight guide of a frame.

At this time, an air nozzle may be installed at the first position to cool the first cell by spraying air.

At this time, the controller may operate the air nozzle to cool the first cell when the heat source moves to the second position from the first position.

### ADVANTAGEOUS EFFECTS OF INVENTION

According to the configurations described above, the over-soldering prevented tabbing device for manufacturing solar cell modules according to the present disclosure may prevent the over-soldering to the cell by moving the soldering head equipped with the heat source to the standby cell when the tabbing device stops and then returning to the original position when re-operated.

### BRIEF DESCRIPTION OF DRAWINGS

FIG. 1 is a perspective view illustrating an over-soldering prevented tabbing device for manufacturing solar cell modules according to an embodiment of the present disclosure.
FIG. 2 is a perspective view of an over-soldering prevented tabbing device for manufacturing solar cell modules according to an embodiment of the present invention when stopped.
FIG. 3 is a perspective view of an over-soldering prevented tabbing device for manufacturing solar cell modules according to an embodiment of the present invention when returned.
FIG. 4 is a schematic block diagram for describing the operation of an over-soldering prevented tabbing device for manufacturing solar cell modules according to an embodiment of the present disclosure.
FIG. 5 is a schematic block diagram for describing the operation of an over-soldering prevented tabbing device for manufacturing solar cell modules according to an embodiment of the present disclosure when stopped.
FIG. 6 is a schematic block diagram for describing the operation of an over-soldering prevented tabbing device for manufacturing solar cell modules according to an embodiment of the present disclosure when returned.

### MODE OF INVENTION

The words and terms used in this specification and claims are not to be construed as limited to a conventional or dictionary meaning but should be construed as meanings and concepts consistent with the technical idea of the present invention in accordance with the principle by which the inventor may define terms and concepts in order to explain his or her invention in the best way.

Therefore, the embodiments described in this specification and the configurations shown in the drawings correspond to a preferred embodiment of the present invention, and do not represent the entire technical idea of the present invention, so the configurations may have various equivalents and variations to replace them at the time of filing of the present invention.

In this specification, terms such as "comprise" or "have" are intended to describe the existence of features, numbers, steps, operations, components, parts, or combinations thereof described in the specification, but it should be understood that the presence or additional possibilities of one or more other features, numbers, steps, operations, components, parts, or combinations thereof are not precluded.

The fact that a component is in the "front", "back", "top" or "bottom" of another component includes being placed in the "front", "back", "top" or "bottom" in direct contact with the other component, unless otherwise specified, as well as another component being placed in the middle. In addition, the fact that a component is "connected" to another component includes not only being directly connected to each other, but also indirectly connected to each other, unless otherwise specified.

Hereinafter, an over-soldering prevented tabbing device for manufacturing solar cell modules according to an embodiment of the present disclosure will be described with reference to the drawings.

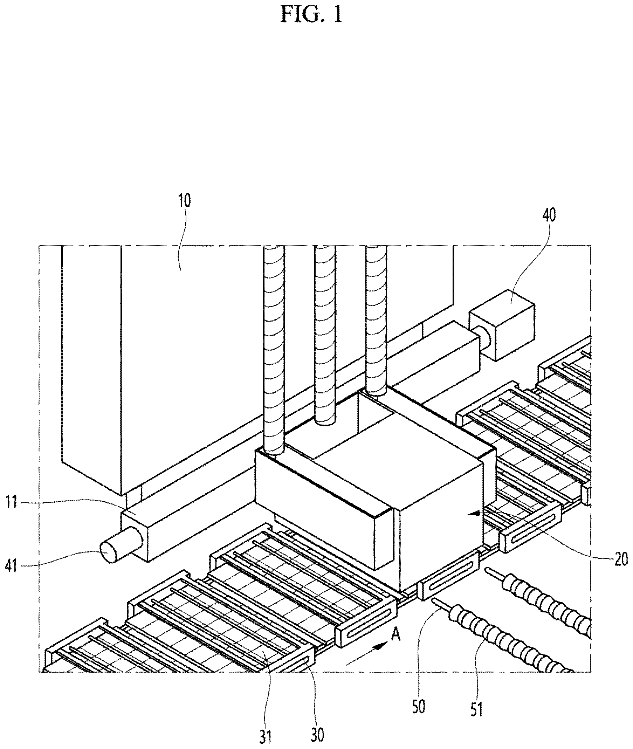

Referring to FIGS. 1 to 6, an over-soldering prevented tabbing device for manufacturing solar cell modules according to an embodiment of the present disclosure may include a solar cell module cell 31, a soldering head 20, a driver 40, and a controller.

Referring to FIGS. 1 to 6, the solar cell module cell 31 may be transported on a conveyor 30 by a unit of cell.

At this time, the controller may control the speed of the conveyor 30 as pre-programmed. The conveyor 30 may be operated under the control of the controller, and as a result, the time of a heat source provided to the solar cell is determined, and accordingly, a soldering may be performed appropriately.

At this time, a solar cell module may be transported on the conveyor 30 by a unit of cell, and soldering flux is applied to the solar cell module cells 31 for electrical connection to form a solar cell module. The flux is soldered by the heat source.

Referring to FIGS. 1 to 6, the soldering head 20 may be installed above the solar cell module cell 31 and may have a built-in heat source that provides heat for soldering the flux coated on the transported solar cell module cell 31.

At this time, the soldering head 31 is originally fixed to a frame 10 of an entire device and does not move in most cases. Therefore, when the conveyor 30 stops during operation, over-soldering occurs in the solar cell module cell 31 that is positioned under the heat source. At this time, according to the present disclosure, the controller may move the position of the soldering head 20.

At this time, an infrared lamp (IR lamp) 21, which is the heat source, may be installed in the soldering head 20, and many other components for the soldering may be installed, for example, an air nozzle may be installed for directly providing air inside to control temperature or a ventilation device may be installed.

At this time, the soldering head 20 may be guided and transported with being supported by a straight guide 11 of the frame 10. Herein, the straight guide 11 may be fixedly installed on the frame 10, a guide rod 41 may be inserted into the straight guide 11, and the guide rod 10 may be connected to the soldering head 20. Therefore, the soldering head 20 may be driven in a straight direction according to the guidance of the straight guide 11.

Referring to FIGS. 1 to 3, the driver 40 may drive the soldering head 20 to reciprocate in a direction along which the conveyor 30 moves.

At this time, the driver 40 may use a cylinder method in the present disclosure. In addition, a motor, screw, and nut type straight driving method may be adopted.

Referring to FIGS. 1 to 6, the controller may control the driver 40.

At this time, when the tabbing device is stopped, the controller may control the driver 40 to move the heat source from a first position B of a first cell that is positioned under the heat source and on which the soldering is performed among the solar cell module cells 31 to a second position A that is a cell position of one of adjacent standby cells.

At this time, the controller may control the driver 40 to position the heat source over the second cell that is closest to the first cell among the standby cells.

At this time, the controller may control the driver 40 to return the heat source to the first position B from the second position A when the tabbing device is re-operated.

At this time, the controller may control the position of the soldering head 20 in the end in such a way that when the conveyor 30 is stopped due to external circumstances or other reasons, the soldering head 20 is moved by one cell unit from the first position B to the second position A at which the standby cell is positioned, and is returned to the first position B, which is an original position, by one cell unit when the conveyor 30 moves again.

At this time, the controller may control the infrared lamp 21 turned off from the time when the tabbing device is stopped until the time when re-operated.

Accordingly, the solar cell module cell which is stopped at the first position B may be prevented from being over soldered, and at the same time, the standby solar cell module cell which is positioned at the second position A may be preheated.

Meanwhile, in the tabbing device according to an embodiment of the present disclosure, an air nozzle 50 may be installed at the first position B to cool the first cell by spraying air.

At this time, the air nozzle 50 may be installed on the outer side of the soldering head 20 and be connected to a pump by a plurality of joints 51, so that the operator may easily adjust an injection position by bending or stretching the joint 51.

At this time, the controller may control the air nozzle 50 to cool the first cell when the heat source is moved from the first position B to the second position A.

Referring to FIG. 1, the over-soldering prevented tabbing device for manufacturing solar cell modules according to an embodiment of the present disclosure is illustrated in a normal working state. A plurality of solar cell module cells 31 may be placed on the conveyor 30 at regular intervals and move along the direction of the conveyor 30 by the operation of the conveyor 30. At this time, the soldering head 20 may be positioned at the first position B, and each solar cell module cell 31, which is being transported on the conveyor 30, may be soldered at the first position B by the infrared lamp 21 of the heat source and move ahead on for the subsequent work.

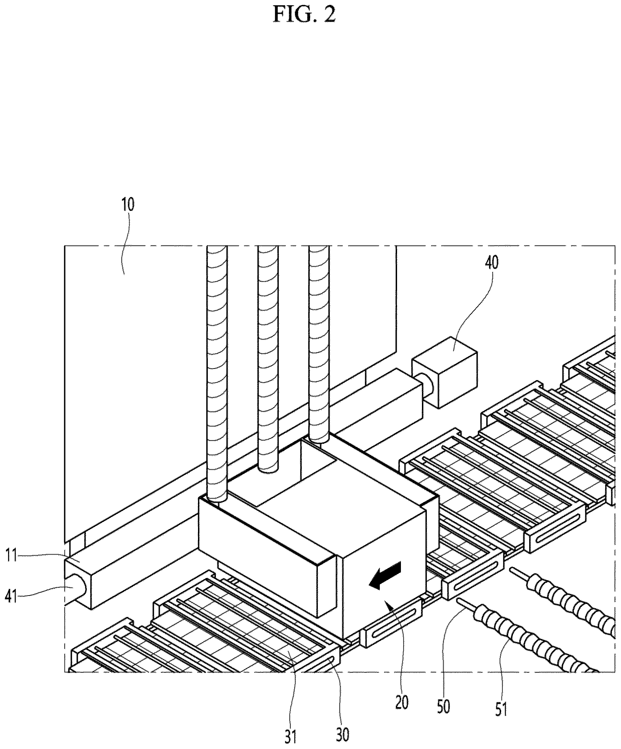

Referring to FIG. 2, an operation state is illustrated when the over-soldering prevented tabbing device for manufacturing solar cell modules according to an embodiment of the present disclosure is stopped. When the tabbing device is stopped for some reasons, the controller may detect this and control the driver 40 to work. By the operation of the driver 40, the soldering head 20 may move backwards to the second position A from the first position B in the direction of the conveyor 30. At the same time, the controller may control the lamp 21 to be turned off. Accordingly, the soldering head 20 may be positioned over the closest standby cell and preheat the closest standby cell at the second position A. At the same time, air is sprayed from the air nozzle 50 to cool the cell positioned at the first position B.

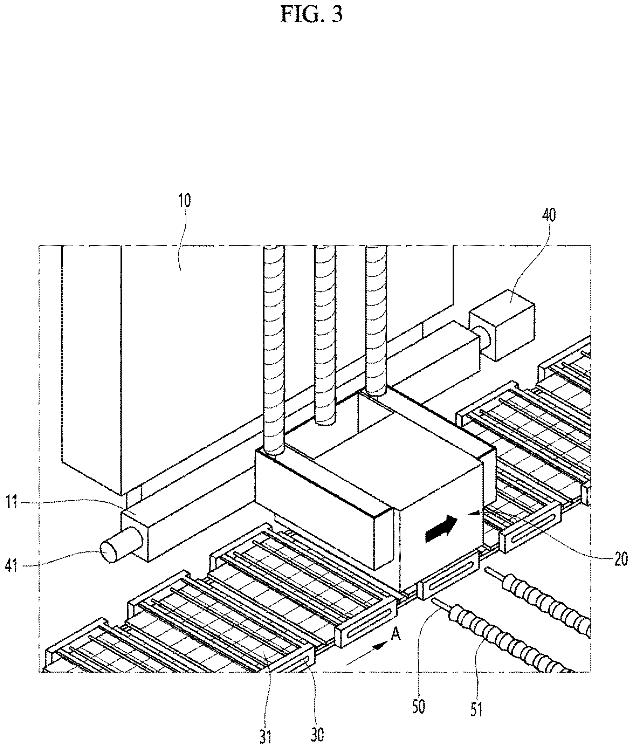

Referring to FIG. 3, an operation state is illustrated when the over-soldering prevented tabbing device for manufacturing solar cell modules according to an embodiment of the present disclosure is re-operated. When the problem caused by the stop of the tabbing device is solved and the tabbing device begins to operate again, the controller may detect the re-operation and control the driver 40 to return the soldering head 20 to the first position B which is the original position. By the operation of the driver 40, the soldering head 20 may return to the first position B from the second position A, and the controller may control the lamp 21 to be turned on. When the soldering head 20 returns and the lamp 21 turns on, the tabbing process may be performed again as usual, and the controller may stop the operation of the pump and may control the nozzle 50 not to spray air.

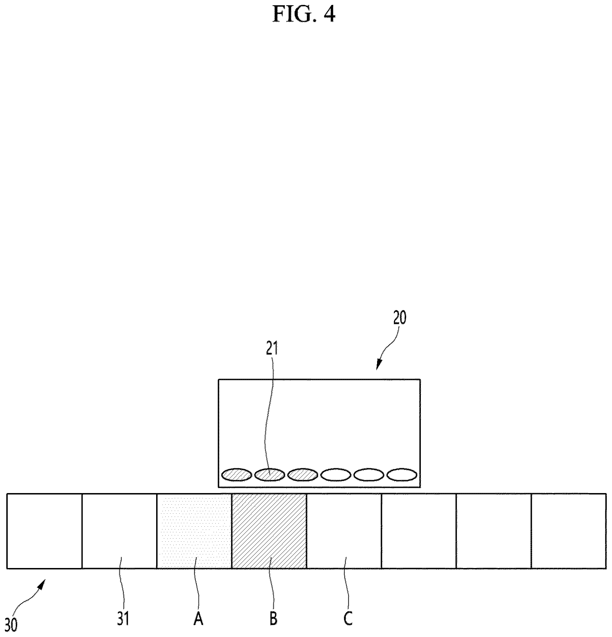

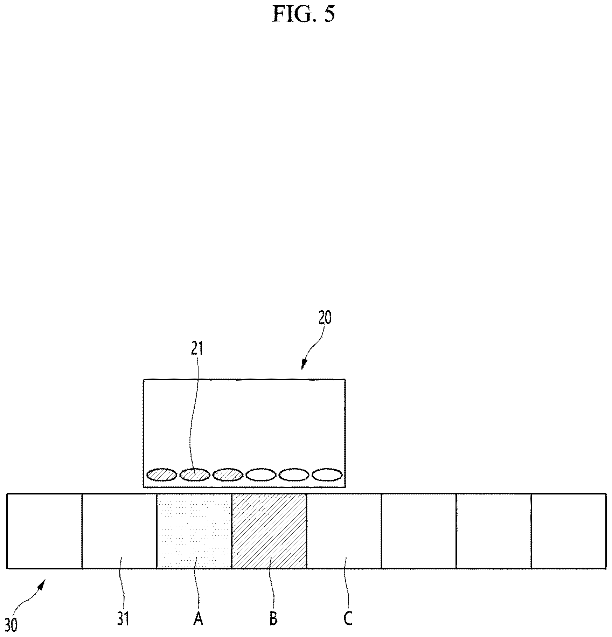

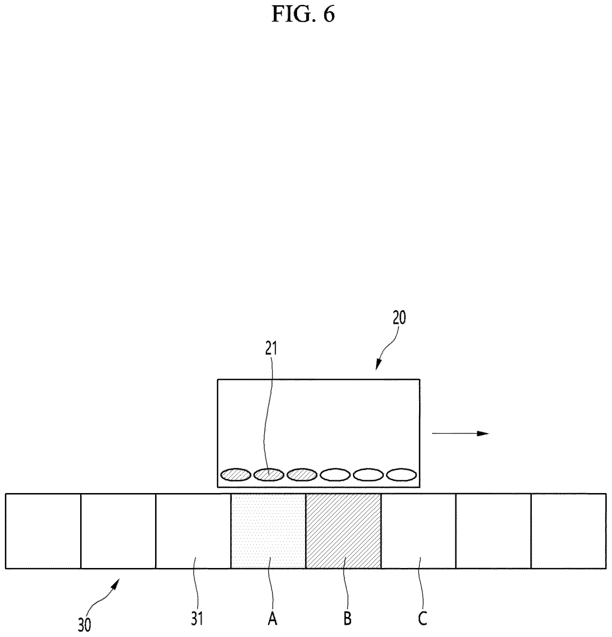

Referring to FIGS. 4 to 6, the operation states of FIGS. 1 to 3 are schematically illustrated, respectively. FIG. 4 illustrates a normal working state in which the soldering head 20 is positioned at the first position B, which is the original position, and FIG. 5 illustrates a stop state of the tabbing device in which the soldering head 20 moves to the second position A from the first position B to thereby prevent the over-soldering. Lastly, referring to FIG. 6, when the stop state is solved and re-operation is performed, the soldering head 20 may return to the first position B from the second position A and the tabbing process may be performed again as usual, and the solar cell to which the soldering is completed is moved to a third position C.

Although the embodiments of the present invention have been described, the spirit of the present invention is not limited to the embodiments presented in this specification, and those skilled in the art who understand the spirit of the present invention may easily propose other embodiments by adding, changing, deleting, or supplementing components within the scope of the same spirit, but this will also be said to fall within the scope of the present invention.

### INDUSTRIAL APPLICABILITY

The present disclosure is applicable to manufacturing technology for solar modules.

## Claims

1. An over-soldering prevented tabbing device for manufacturing solar cell modules, the tabbing device comprising: a solar cell module cell that is transported on a conveyor by a unit of cell; a soldering head installed above the solar cell module cell and having a built-in heat source that provides heat to solder flux coated on the solar cell module cell transported; a driver reciprocating the soldering head in a direction in which the conveyor moves; and a controller controlling the driver.

2. The over-soldering prevented tabbing device for manufacturing solar cell modules of claim 1, wherein the soldering head is an infrared lamp.

3. The over-soldering prevented tabbing device for manufacturing solar cell modules of claim 1, wherein when the tabbing device stops, the controller controls the driver to move the heat source from a first position of a first cell that is positioned under the heat source and on which a soldering is performed to a second position that is a cell position of one of adjacent standby cells, from among the solar cell module cells.

4. The over-soldering prevented tabbing device for manufacturing solar cell modules of claim 3, wherein the controller controls the driver to position the heat source above the second cell that is closest to the first cell among the standby cells.

5. The over-soldering prevented tabbing device for manufacturing solar cell modules of claim 3, wherein when the tabbing device is re-operated, the controller controls the driver to return the heat source to the first position from the second position.

6. The over-soldering prevented tabbing device for manufacturing solar cell modules of claim 1, wherein the soldering head is guided and transported with being supported by a straight guide of a frame.

7. The over-soldering prevented tabbing device for manufacturing solar cell modules of claim 3, wherein an air nozzle is installed at the first position to cool the first cell by spraying air.

8. The over-soldering prevented tabbing device for manufacturing solar cell modules of claim 7, wherein the controller operates the air nozzle to cool the first cell when the heat source moves to the second position from the first position.
